# EUROPÄISCHE PATENTSCHRIFT

(11) **EP 0 588 397 B1**
(45) Veröffentlichungstag und Bekanntmachung des Hinweises auf die Patenterteilung: **04.06.1997**
(21) Anmeldenummer: 93202357.5
(22) Anmeldetag: 11.08.1993
(51) Int. Cl.: H01L 27/146, H01L 31/08, H01L 31/115, H01L 31/117, H01L 31/0224

(54) **Röntgenbilddetektor**
X-ray image detector
Détecteur d'images radiologiques

(30) Priorität: 17.08.1992 DE 4227096
(43) Veröffentlichungstag der Anmeldung: 23.03.1994
(73) Patentinhaber: Philips Patentverwaltung GmbH, 22335 Hamburg (DE); Philips Electronics N.V., 5621 BA Eindhoven (NL)
(72) Erfinder: Schiebel, Ulrich, Dr., c/o Philips Patentverw., D-20097 Hamburg (DE); Wieczorek, Herfried, Dr., c/o Philips Patentverw., D-20097 Hamburg (DE); Brauers, Andreas, Dr., c/o Philips Patentverw., D-20097 Hamburg (DE)
(74) Vertreter: Hartmann, Heinrich, Dipl.-Ing.

(56) Entgegenhaltungen:
- EP-A- 0 316 222
- EP-A- 0 428 050
- EP-A- 0 444 720
- GB-A- 2 037 077
- US-A- 4 471 371
- US-A- 5 117 114
- PATENT ABSTRACTS OF JAPAN vol. 10, no. 137 (E-405)21. Mai 1986 & JP-A-61 001 177 (HITACHI SEISAKUSHO KK)

## Beschreibung

Die Erfindung betrifft einen Röntgenbilddetektor mit einer Vielzahl von für Röntgenstrahlung empfindlichen Sensoren mit folgenden Merkmalen:
- Jeder Sensor enthält eine Sammelelektrode und ein Schaltelement, das die Sammelelektrode mit einer Ausgangsleitung verbindet;
- zwischen den einzelnen Sammelelektroden und einer Vorspannungselektrode befindet sich eine Photoleiterschicht;
- die Sammelelektroden bilden zusammen mit Bezugselektroden Kapazitäten, die durch im Photoleiter erzeugte Ladungsträger aufladbar sind.

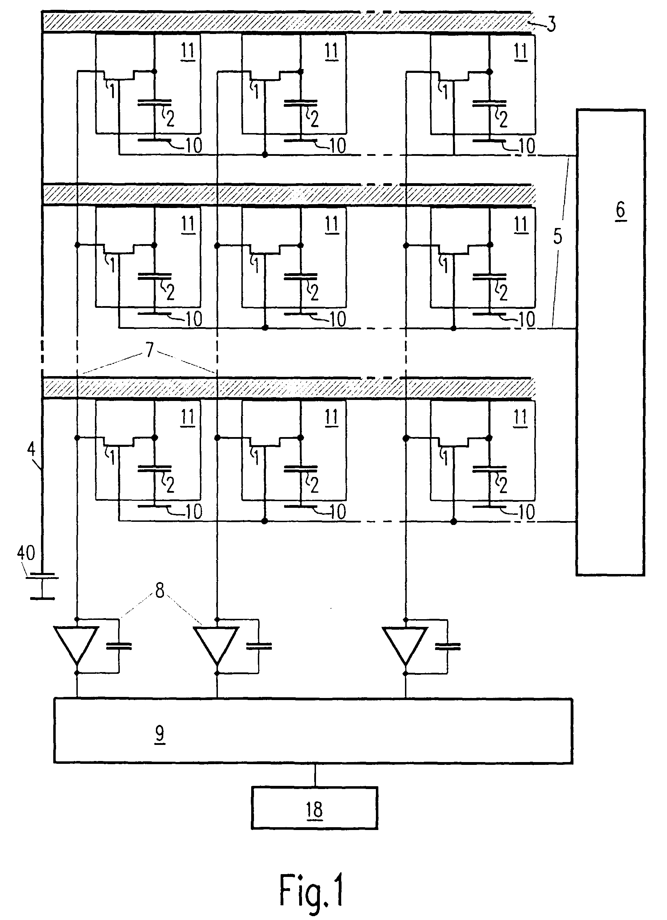

Mit derartigen Röntgenbilddetektoren sollen u.a. Durchleuchtungen durchgeführt werden, bei denen Röntgenaufnahmen in dichter zeitlicher Folge, z.B. 60 Bilder / sec. anfallen. Ein solcher Röntgenbilddetektor, der aus der EP-OS 444 720 (PHD 90-016 EP) bekannt ist, ist in Fig. 1 schematisch dargestellt. Für jeden Bildpunkt (Pixel) ist ein Sensor vorgesehen, der ein Schaltelement 1, eine Kapazität 2 sowie einen Photosensor umfaßt. Die typischerweise 2000 x 2000 Schaltelemente werden auf einem gemeinsamen dielektrischen Substrat (Glas) in Dünnschichttechnik realisiert (beispielsweise in Form von Dünnfilm- Feldeffekttransistoren 1, wie in Fig. 1 angedeutet.) Die Photosensoren werden durch eine durchgehende, das ganze Bildfeld bedeckende Photoleiterschicht 3, eine Vorspannungselektrode 4, die auf die Photoleiterschicht aufgebracht ist und für jedes Bildelement eine gesonderte, auf der anderen Seite der Photoleiterschicht befindliche Sammelelektrode 11 gebildet. Wenn im Betriebszustand der Bilddetektor von Röntgenstrahlung getroffen wird, werden in der Photoleiterschicht 3 Ladungsträger erzeugt, die unter dem Einfluß eines elektrischen Feldes, das mittels einer an die Vorspannungselektrode 4 angeschlossenen Vorspannungsquelle 40 erzeugt wird, durch den Photoleiter zu den Sammelelektroden 11 fließen. Dadurch werden die mit den Sammelelektroden 11 verbundenen Kapazitäten 2 aufgeladen, deren andere Elektrode an eine Elektrode 10 auf Bezugspotential angeschlossen ist.

Die Sensoren sind nach Art einer Matrix zeilen- und spaltenweise angeordnet, wobei der Abstand der Zeilen und der Spalten voneinander gleich ist. Dieser Abstand bestimmt das räumliche Auflösungsvermögen. Zum Auslesen werden mittels einer Ansteuerschaltung 6 die Gate-Elektroden der die Schaltelemente bildenden Dünnfilm-Feldeffekttransistoren zeilenweise durchgeschaltet. Zu diesem Zweck sind die Gate-Elektroden aller Schaltelemente einer Zeile jeweils mit einer gemeinsamen Schaltleitung 5 verbunden. Die Source-Elektroden der Dünnfilm-Feldeffekttransistoren sind jeweils mit der ihnen zugeordneten Kapazität verbunden, während ihre Drain-Elektroden spaltenweise an einer gemeinsamen Ausgangsleitung 7 angeschlossen sind.

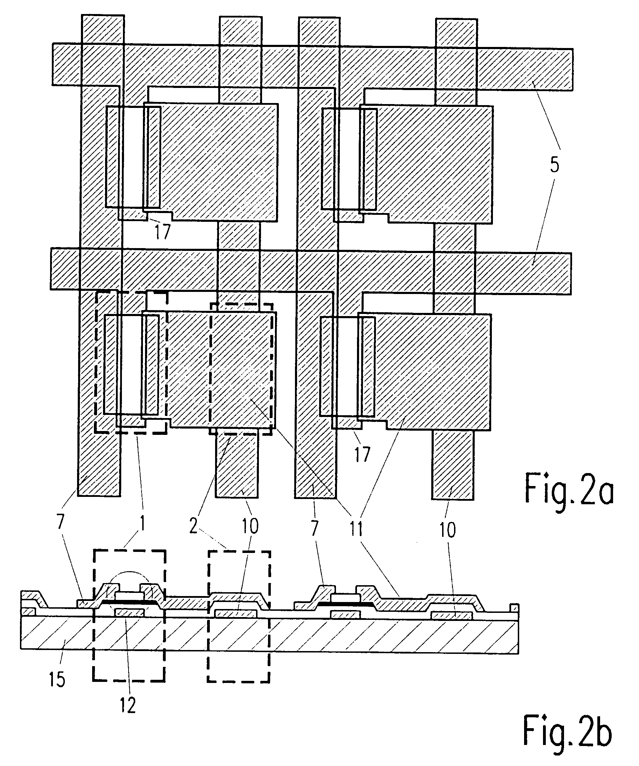

In den Fig. 2a und 2b ist eine Draufsicht bzw. ein Querschnitt von einem Teil des Bilddetektors dargestellt, wobei die Photoleiterschicht 3 und die Vorspannungselektrode 4 weggelassen sind. Die Darstellung ist stark vereinfacht, zeigt aber die wesentlichen Elemente. Auf ein Substrat 15 sind die Masseleitung 10 sowie die Schaltleitungen 5 aufgebracht. Die Schaltleitungen 5 sind mit senkrechten Abgriffen 17 versehen, die die Gate-Elektroden der Dünnfilm-Feldeffekttransistoren bilden. Oberhalb der Gate-Elektrode 17 befindet sich eine Mehrschichtstruktur 12 aus Halbleiter- und Isolierschichten, die zusammen mit den Elektroden 7 (Drain) und 11 (Source) einen Dünnfilm-Feldeffekttransistor bildet. Die Elektrode 11 hat somit die Funktion der Sammel- und der Source-Elektrode, und außerdem bildet sie zusammen mit einer von ihr überdeckten Masseleitung 10 und einem dazwischenliegenden Dielektrikum die Speicherkapazität 2.

Bei der in Dünnschichttechnik realisierten Anordnung nach Fig. 2 sind die Schichten zwischen den Elektroden sehr dünn (in der Größenordnung von 0,2 - 1 µm). Deshalb ist es wichtig, daß die Sammelektroden 11 die Schaltleitungen 5, insbesondere aber die Ausgangsleitungen 7 nicht überdecken, weil sich dadurch große parasitäre Kapazitäten zwischen der Sammelelektrode 11 und den betreffenden Elektroden bilden würden. Dies würde im Falle der Ausgangsleitungen 7 zu einer kapazitiven Signalauskopplung und damit zu einer Verkleinerung des auslesbaren Signals führen sowie zu erhöhtem Rauschen der an die Ausgangsleitungen 7 angeschlossenen Ausgangsverstärker 8, da diese eine größere Eingangskapazität "sehen". Die Sammelelektroden 11 einerseits und die Leitungen 5, 7 andererseits müssen also nebeneinander angeordnet sein, d.h. die Sammelelektroden dürfen sich in der Draufsicht gem. Fig. 2a nicht mit den Leitungen 5 und 7 überlappen. Sie müssen sich also auf die zwischen zwei benachbarten Schaltleitungen 5 bzw. zwei benachbarten Ausgangsleitungen 7 verbleibende Fläche beschränken.

Da alle Leitungen 5, 7 und 10 eine Breite zwischen 10 und 25 µm aufweisen müssen, um eine genügend hohe Leitfähigkeit zu erreichen, bedeutet dies, daß der Anteil der Sammelelektroden an der Gesamtfläche eines Röntgenbilddetektors umso kleiner ist, je kleiner die Bildpunkte (Pixel) bzw. ihr Abstand voneinander ist, d.h., je größer das Auflösungsvermögen ist.

Aufgabe der vorliegenden Erfindung ist es, einen Röntgenbilddetektor zu schaffen, der auch bei hohem räumlichen Auflösungsvermögen eine gute Empfindlichkeit bei gleichzeitig möglichst kapazitätsarmem Aufbau aufweist.

Diese Aufgabe wird ausgehend von einem Röntgenbilddetektor der eingangs genannten Art erfindungsgemäß dadurch gelöst, daß die Sammelelektroden je zwei in elektrischen Kontakt miteinander befindliche Elektrodenteile umfassen, daß der erste Elektrodenteil jeweils in einem Bereich neben der Ausgangsleitung angeordnet ist, daß der zweite Elektrodenteil eine größere Fläche hat als der erste Elektrodenteil und sich zwischen diesem und der Vorspannungselektrode befindet, und daß sich zwischen dem zweiten Elektrodenteil und der Ausgangsleitung eine Isolierschicht befindet.

Durch die Verwendung einer aus zwei Elektrodenteilen bestehenden Sammelelektrode teilen sich auch deren Funktionen auf: Der erste Elektrodenteil bildet zusammen mit einer der Bezugs- bzw. Masseelektroden 10 eine Kapazität und stellt gleichzeitig eine Elektrode des Schaltelements dar, während der zweite Elektrodenteil die in der Photoleiterschicht erzeugten Ladungsträger sammelt. Für diesen zweiten Elektrodenteil gelten die Beschränkungen nicht, denen der erste Elektrodenteil unterliegt, d.h. der zweite Elektrodenteil kann die Leitungen, insbesondere die Ausgangsleitungen, wenigstens teilweise überdecken, so daß sich eine vergleichsweise große Empfindlichkeit ergibt. Die zwischen diesem zweiten Elektrodenteil und den Leitungen resultierenden parasitären Kapazitäten lassen sich dadurch klein halten, daß die Isolierschicht genügend dick gemacht wird.

An dieser Stelle sei auf die JP-OS 61-1177 bzw. auf die US-PS 4,471,371 verwiesen, sich auf einen Dünnfilm-Bilddetektor für sichtbares Licht beziehen. Bilddetektoren für sichtbares Licht unterscheiden sich von Röntgenbilddetektoren dadurch, daß sie anstelle einer relativ dicken Photoleiterschicht nur eine dünne Halbleiterschicht aufweisen, beispielsweise aus amorphem Silizium. Dadurch ergibt sich eine relativ große Kapazität, so daß eine gesonderte Kapazität - wie die Kapazität 2 - nicht erforderlich ist. Bei den bekannten Bilddetektoren befinden sich die Elektroden der Schaltelemente bzw. die Ausgangsleitung in einer Ebene, die von der Ebene, in der sich die Sammelelektroden befinden, durch eine in Dünnschichttechnik erzeugte Isolierschicht getrennt ist. Dadurch ergeben sich zwischen den Elektroden des Schaltelements und der Sammelelektrode sehr hohe parasitäre Kapazitäten, die bei einem Röntgenbilddetektor, der mit hoher Bildfrequenz auslesbar sein soll, nicht hingenommen werden können.

Eine zweite Lösung des der Erfindung zugrundeliegenden Problems ist ausgehend von einem Röntgenbilddetektor der eingangs genannten Art gekennzeichnet durch folgende Merkmale:
- Die Sammelelektrode ist neben der Ausgangsleitung angeordnet;
- das Schaltelement und die Ausgangsleitung sind von einer Isolierschicht bedeckt;
- die Isolierschicht und die Sammelelektrode sind von einer halbleitenden Schicht bedeckt;
- die halbleitende Schicht ist so dotiert, daß sie für die in Richtung zur Sammelelektrode fließenden Ladungsträger eine im Vergleich zur Leitfähigkeit für Ladungsträger mit entgegengesetzter Polarität große Leitfähigkeit aufweist.

Bei dieser Lösung bilden sich oberhalb der durch die Isolierschicht passivierten Bereiche in der halbleitenden Schicht Raumladungen, die das elektrische Feld in der Photoleiterschicht so verformen, daß auch Ladungsträger, die nicht oberhalb der mit der halbleitenden Schicht in Kontakt stehenden Sammelelektroden erzeugt werden, diese erreichen können. Trotz vergleichsweise kleiner Flächen der Sammelelektroden ergibt auch diese Lösung eine gute Empfindlichkeit. In weiterer Ausgestaltung dieser Lösung ist vorgesehen, daß sich zwischen der halbleitenden Schicht und den Sammelelektroden eine zusätzliche halbleitende Schicht befindet, die sowohl für positive als auch für negative Ladungsträger eine geringe Leitfähigkeit aufweist. Diese zusätzliche halbleitende Schicht dient zum Aufbau einer Raumladung im Bereich neben den Sammelelektroden. Die Raumladung verzerrt das elektrische Feld derart, daß die signalgebenden Ladungsträger in der darüber liegenden halbleitenden Schicht, die für diese eine gute Leitfähigkeit hat, zur Sammelelektrode transportiert werden - und zwar auch dann, wenn sie nicht im Bereich oberhalb der Sammelelektrode erzeugt wurden.

Eine für beide Lösungen geeignete Weiterbildung der Erfindung sieht vor, daß beiderseits der Photoleiterschicht Schichten mit einer im Vergleich zum Photoleiter geringen Dicke vorgesehen sind, die so dotiert sind, daß sie für die Ladungsträger, die aus dem Photoleiter auf die ihnen benachbarten Elektroden zufließen, eine im Vergleich zur Leitfähigkeit für Ladungsträger mit der entgegengesetzten Polarität große Leitfähigkeit aufweisen. Die beiden Schichten beiderseits der Photoleiterschicht blockieren von den Sammelelektroden oder von der Vorspannungselektrode injizierte Ladungsträger, wodurch die Dunkelentladungsraten verringert werden. In weiterer Ausgestaltung ist vorgesehen, daß zwischen der Vorspannungselektrode und der ihr benachbarten Schicht eine Schicht angebracht ist, die aus dem gleichen Material besteht wie die Photoleiterschicht, aber wesentlich dünner ist als diese. Dadurch werden die Dunkelentladungsraten noch einmal entscheidend verringert.

Die Erfindung wird nachstehend anhand der Zeichnungen näher erläutert. Es zeigen:
- Fig. 1: ein Schaltschema des erfindungsgemäßen, bzw. des bekannten Röntgenbilddetektors.
- Fig. 2: eine Dünnschichtstruktur eines solchen Detektors in der Draufsicht (Fig. 2a) und im Querschnitt (Fig. 2b).
- Fig. 3: eine erste Ausführungsform eines erfindungsgemäßen Detektors in der Draufsicht (Fig. 3a) und im Querschnitt (Fig. 3b).
- Fig. 4: eine verbesserte Ausführungsform eines solchen Detektors im Querschnitt.
- Fig. 5: eine andere Ausführungsform eines erfindungsgemäßen Detektors in der Draufsicht (Fig. 5a) und im Querschnitt (Fig. 5b).
- Fig. 6: die elektrischen Feldlinien bei der Anordnung nach Fig. 5b und

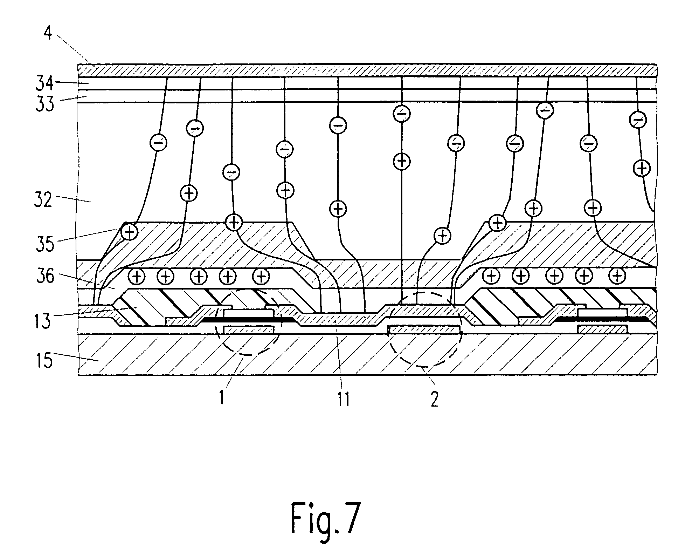

- Fig. 7: eine verbesserte Ausführungsform im Querschnitt.
- Fig. 8: eine verbesserte Ausführungsform im Querschnitt.

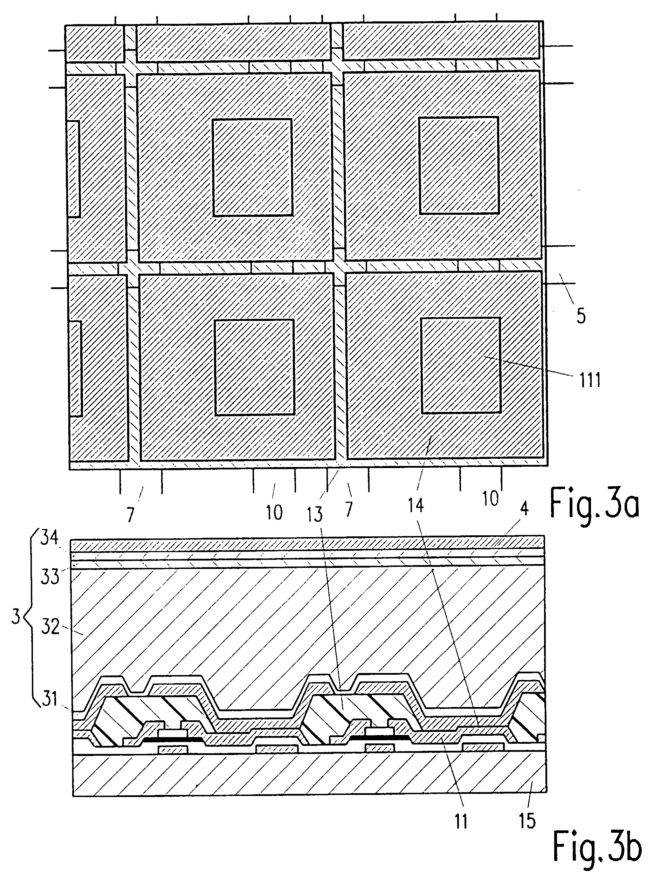

Bei der in Fig. 3 in der Draufsicht bzw. im Querschnitt dargestellten Ausführungsform eines Röntgenbilddetektors sind für gleiche Teile die gleichen Bezugszeichen verwendet wie in Fig. 2. Der in Fig. 3b dargestellte Querschnitt ist nicht maßstäblich und auch die Relationen zwischen den Dicken der einzelnen Schichten entsprechen nicht den tatsächlichen Verhältnissen, die sich aus der folgenden Beschreibung ergeben. Auf die in Fig. 2 dargestellte Dünnschichtstruktur wird zunächst eine isolierende Schicht 13 mit einer ebenen Abschlußfläche aufgebracht. In dieser Abschlußfläche werden oberhalb der Sammelelektroden 11 mit Hilfe von photolithographischen Verfahren Kontaktlöcher angebracht, die bis zu den Elektroden 11 reichen.

Danach wird eine metallische Schicht aufgebracht, beispielsweise durch Abscheiden aus der Dampfphase. Diese durchgehende Schicht aus vorzugsweise Aluminium wird dann durch ein photolitographisches Verfahren so strukturiert, daß für die einzelnen Bildpunkte möglichst großflächige Elektroden 14 entstehen, die die für jeweils einen Bildpunkt zur Verfügung stehende Fläche möglichst vollständig bedecken und die durch die Kontaktlöcher hindurch mit den darunter befindlichen Elektroden 11 elektrischen Kontakt haben. Der Abstand zwischen den einander zugewandten Kanten benachbarter Sammelelektroden kann dabei zwischen 5 und 15 µm liegen, so daß das Verhältnis zwischen der Sammelelektrodenfläche und der für einen Bildpunkt zur Verfügung stehenden Fläche auch bei einer Bildpunktgröße von 100 µm noch bis zu 90 % betragen kann. Die Elektroden 14 können somit einen wesentlich größeren Teil der im Photoleiter erzeugten Ladungsträger auffangen als die Elektroden 11, so daß sich eine verbesserte Empfindlichkeit ergibt.

Bei diesen Abmessungen der die Elektroden 11 allseits überdeckenden Elektroden 14, ist es unausbleiblich, daß sie auch die Ausleseleitungen und die Ansteuerleitungen - zumindest teilweise - überdecken, womit sich zusätzliche parasitäre Kapazitäten zwischen der Elektrode 11 sowie den Leitungen 7 und 5 ausbilden. Um diese parasitären Kapazitäten möglichst klein zu halten, muß die isolierende Schicht 13 eine Dicke von mindestens 3 µm, vorzugsweise 5 bis 10 µm aufweisen. Dabei wird von einer relativen Dielektrizitätskonstanten von 4 bis 5 ausgegangen, (bei einer höheren Dielektrizitätskonstanten muß die isolierende Schicht noch größer sein). Als geeignete Materialien kommen Siliziumoxid, Siliziumnitrid oder Polyimid in Frage.

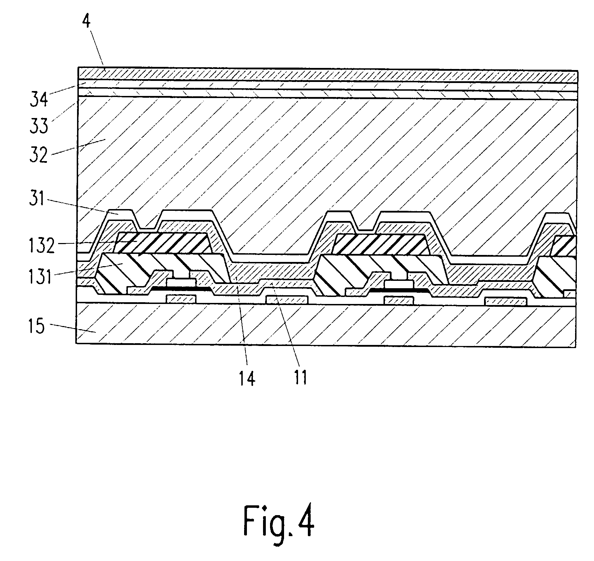

Um diese relativ großen Schichtdicken zu erreichen, wird die Isolierschicht bevorzugt in mehreren Einzelschichten von jeweils geringerer Dicke aufgebracht. Dies ist in Fig. 4 dargestellt, wobei die isolierende Schicht durch die Teilschichten 131 und 132 gebildet wird. Die zwecks Kontaktierung der Elektrodenteile 11 und 14 vorgesehenen Kontaktlöcher haben dabei vorzugsweise eine nach oben hin zunehmende Größe, so daß sich Stufen ergeben, die eine gute Metallisierung durch die Schicht 14 gewährleisten. Dabei kann es von Vorteil sein, für die verschiedenen Teilschichten unterschiedliche Materialien zu verwenden (z.B. kann die Schicht 131 aus Siliziumoxid und die Schicht 132 aus Polyimid bestehen). Verwendet man dann bei dem zur Herstellung der Kontaktlöcher erforderlichen Ätzprozeß Ätzmittel, die jeweils nur eine der Teilschichten angreifen, dann ist es leicht möglich, für die einzelnen Schichten den Ätzprozeß in einer definierten Tiefe zu stoppen.

Auf die nach dem Aufbringen der Elektroden 14 entstandene Struktur wird dann die eigentliche Photoleiterschicht 3 aufgebracht. Die Photoleiterschicht 3 wird abschließend mit einer metallischen Deckelektrode 4 aus Gold oder Aluminium versehen. Dabei kann es sich als vorteilhaft erweisen, den Photoleiter als Mehrschichtstruktur folgendermaßen aufzubauen:

Zunächst wird eine halbleitende Schicht 31 aufgebracht, die negative Ladungsträger praktisch nicht leitet, dafür positive Ladungsträger umso besser. Diese Schicht kann aus verschiedenen Materialien, wie z.B. HgI₂, CdSe, CdTe, PbO oder Se bestehen, deren Leitfähigkeit durch bestimmte Zusätze in obigem Sinn eingestellt wird. Dies wird beispielsweise mit einer 1 - 5 µm dicken Selenschicht erreicht, die mit 20 bis 200 ppm Cl dotiert ist. Darauf wird die eigentliche Photoleiterschicht 32 aus amorphen Selen mit einem Zusatz von 0,1 bis 1 % Arsen abgeschieden. Diese Schicht muß zwischen 200 und 800 µm dick sein, um die Röntgenquanten, die sich bei einer medizinischen Untersuchung ergeben, ausreichend absorbieren zu können. Auf die Schicht 32 wird eine Halbleiterschicht 33 aufgebracht, die so dotiert ist, daß sie positive Ladungsträger, also Löcher (holes) nicht leitet, dafür umso besser die negativen Ladungsträger (Elektronen). Diese Schicht kann z.B. aus Selen bestehen, das mit 20 bis 200 ppm Alkalimetall (Li, Na, K, Cs) bestehen und eine Dicke zwischen 0,5 und 2 µm aufweisen.

Während des Betriebes des Bilddetektors wird eine positive Spannung zwischen 1 und 10 kV an die Vorspannungselektrode 4 angelegt. Die Halbleiterschichten 31 und 33 sollen dann die Ladungsträger blockieren, die evtl. von den Sammelelektroden 14 oder der Deckelektrode 4 injiziert werden, so daß die Dunkelentladungsraten entscheidend reduziert werden. Erstaunlicherweise wird diese Funktion aber nur dann zufriedenstellend erfüllt, wenn zwischen der dotierten Schicht 33 und der Vorspannungselektrode 4 aus Gold oder Aluminium noch eine dünne halbleitende Schicht, die für negative und positive Ladungsträger wenig leitend ist, z.B. eine Selenschicht, die auf die gleiche Weise mit Arsen dotiert ist wie die eigentliche Photoleiterschicht 32. Damit können bei einer Dicke der Schicht 32 von 0,3 mm bis zu 5 kV an die Vorspannungselektrode angelegt werden, ohne daß es nennenswerte Dunkelströme (mit einer Dichte von mehr als 1 pA/cm²) gibt.

Das Auslesen eines Röntgenbildes mit einem derartigen Röntgenbilddetektor erfolgt in ähnlicher Weise wie in der EP-OS 444 720 beschrieben. Bevor die Röntgenstrahlung eingeschaltet wird, sind die Schaltelemente 1 geschlossen (leitend), so daß sich die Kapazitäten 2 nicht aufladen können. Die Röntgenbelichtung kann mit einer Bildfrequenz von z.B. 60 Bildern/sec erfolgen, wobei die Dosis für die Bilder zwischen 10 nGy und 50 µGy liegen soll.

Während der Röntgenbelichtung sind die Schalter 1 normalerweise geöffnet. Zum Auslesen des Röntgenbildes werden jeweils alle Schaltelemente einer einzigen Zeile gleichzeitig für eine kurze Zeit (10 bis 20 µs) geschlossen, indem an die zugehörige Schaltleitung 5 ein entsprechendes Potential angelegt wird. Während dieser Zeit fließen die aus den Kapazitäten 2 gesammelten Ladungen über die Ausgangsleitungen 7 auf die Eingänge der Verstärker 8. Die Verstärker sind als Stromintegratoren geschaltet, so daß ihr Ausgangssignal der gesamten vom Kondensator abgeflossenen Ladung entspricht. Dabei werden die Sammelelektroden 11, 14 virtuell auf Erdpotential gehalten. Die Ausgangssignale der Verstärker werden von einem Analogmultiplexer 9 übernommen, der aus den parallel anstehenden Signalen einen seriellen Signalstrom mit entsprechend höherer Bandbreite verformt. Der gesamte Vorgang wird danach für die nächste und sukzessive für alle übrigen Bildzeilen wiederholt.

Die Verstärker 8 können derzeit nicht mit der erforderlichen Empfindlichkeit und Rauscharmut in Dünnschichttechnik realisiert werden. Sie müssen sich daher außerhalb des Dünfilmsubstrats befinden und in konventioneller integrierter Schaltungstechnik realisiert sein. Dabei können jeweils ca. 32 bis 256 Verstärker mit dem zugehörigen Analog-Multiplexer auf einem Chip integriert sein. Für die insgesamt 2000 Bildspalten würden danach also zwischen 8 und 64 derartiger Chips benötigt, deren Eingänge mit denen auf dem Dünnfilmsubstrat befindlichen Ausgangsleitungen zu verbinden wären. Die Ausgänge der Analog-Multiplexer werden mit Analog-Digital-Wandlern verbunden, wonach die digitalen Daten weiterverarbeitet werden.

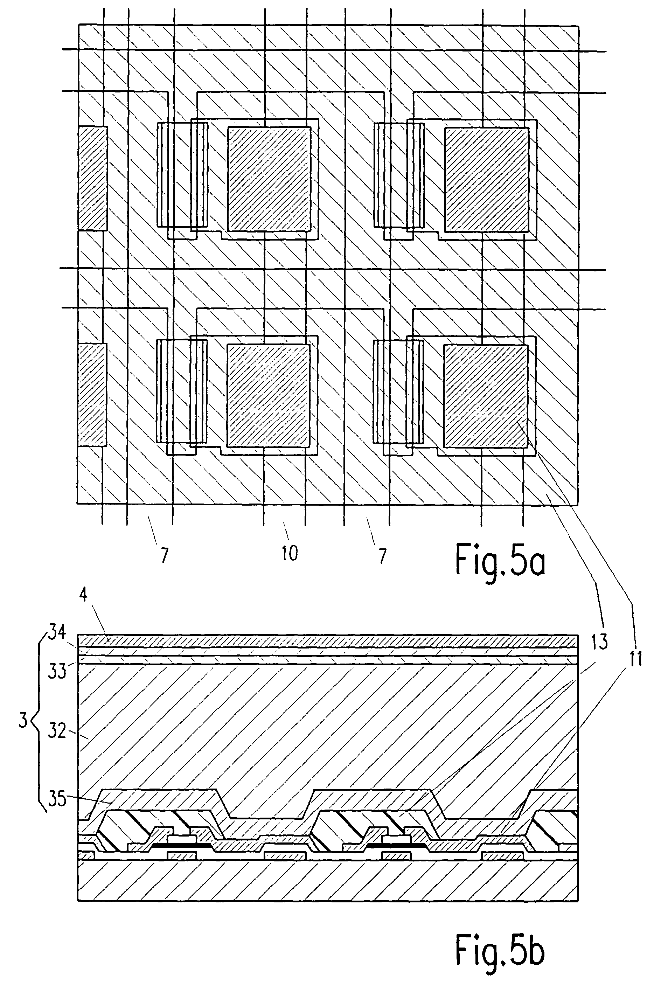

In Fig. 5 ist eine zweite Ausführungsform eines Bilddetektors dargestellt, die sich einfacher herstellen läßt. Die Isolierschicht 13 ist dabei mit einer für Dünnschichttechnik üblichen Schichtdicke (zwischen 0,5 µm und maximal 2 µm) hergestellt, wobei oberhalb jeder der Sammelelektroden jeweils ein bis auf die Sammelelektrode 11 reichendes Kontaktloch vorgesehen ist.

Im folgenden wird am Beispiel des Photoleiters Se eine mögliche Realisierung erörtert. Analoge Strukturen sind auch in anderen Halbleitermaterialien wie z.B. HgI₂, CdTe, CDSe oder PbO zu verwirklichen. Für den Fall, daß - entgegen diesem Beispiel - an die Vorspannungselektrode eine negative Spannung angelegt wird, so daß bei Röntgenbelichtung negative Ladungsträger (Elektronen) zur Sammelelektrode wandern, sind die Schichten mit guter Leitfähigkeit für positive Ladungsträger (Löcher) und schlechter Leitfähigkeit für Elektronen zu vertauschen und umgekehrt. Auf die isolierende Schicht 13 wird eine halbleitende Schicht 35 aufgebracht, die die negativen Ladungsträger nicht leitet, aber eine gute Leitfähigkeit für positive Ladungsträger aufweist. In diesem Beispiel ist es eine Selenschicht, die - wie die Schicht 31 - mit 20 bis 200 ppm CI dotiert ist, die aber dicker ist als die Schicht 31 der Fig. 3, z.B. 5 bis 40 µm. Für die sich daran anschließenden Schichten 32, 33, 34 und 4 gilt, was in Verbindung mit Fig. 3 ausgeführt wurde.

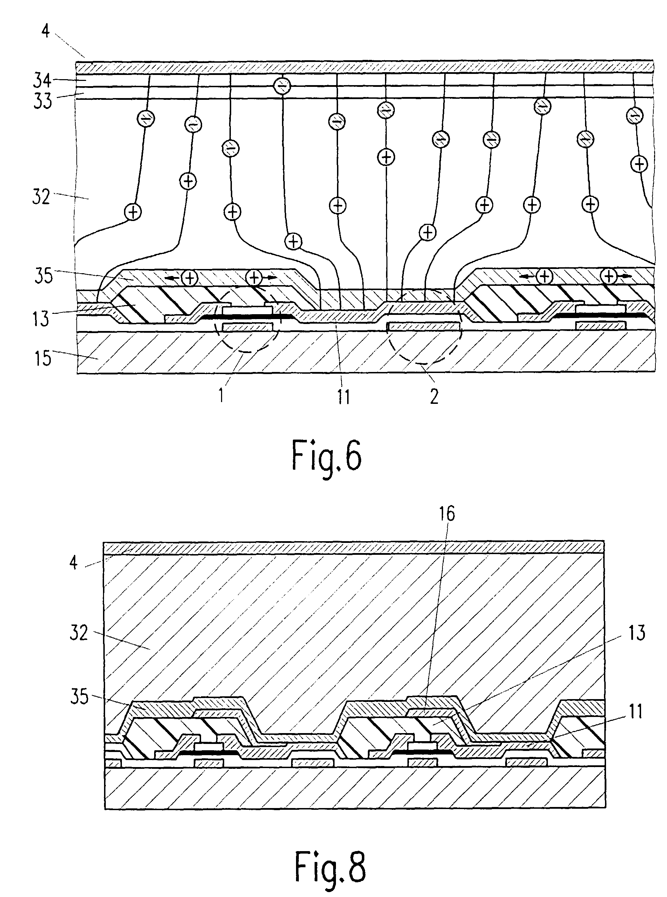

Die Funktionsweise dieser Ausführungsform wird nachstehend anhand von Fig. 6 näher erläutert. Fig. 6 entspricht Fig. 5b, wobei jedoch die elektrischen Feldlinien bzw. die Bahnen der elektrischen Ladungsträger eingezeichnet sind.

Wird an die Vorspannungselektrode 4 eine positive Spannung von z.B. 3 kV angelegt und werden durch Röntgenbelichtung Ladungsträger in der Photoleiterschicht 32, hier z.B. Selen mit 0,1 bis 1 % Arsen dotiert, erzeugt, so bilden sich positive Raumladungen oberhalb der durch die isolierende Schicht 13 passivierten Bereiche. Dadurch wird das elektrische Feld verformt, wie in Fig. 6 angedeutet. Wegen der guten Leitfähigkeit von Schicht 35 für Löcher können nun selbst Ladungsträger, die nicht oberhalb der Sammelelektrode erzeugt wurden, in dieser Schicht mit hoher Geschwindigkeit zur Sammelelektrode gelangen. Evtl. von den Sammelelektroden 11 injizierte Elektronen werden in der Schicht 35 festgehalten; in diesem Punkt wirkt die Schicht analog zur Schicht 31 in Figuren 3 und 4.

Die gute Leitfähigkeit von Schicht 35 für positive Ladungsträger bewirkt allerdings gleichzeitig, daß die Raumladung in dieser Schicht leicht auseinanderfließen kann, wie es in Figur 6 skizziert ist. Dadurch wird im Gleichgewichtszustand die gewünschte Feldverzerrung relativ gering sein. Zudem kann die Feldverzerrung bis in die eigentliche Photoleiterschicht 32 hereinreichen. Diese hat für die positiven Ladungsträger jedoch eine geringe Leitfähigkeit, was den Transport zur Sammelelektrode hemmt.

Eine Weiterentwicklung dieses Detektors ist in Bild 7 dargestellt. Hier ist unter der für Löcher gut und für Elektronen schlecht leitenden Schicht eine weitere Halbleiterschicht 36 eingefügt, die für beide Polaritäten von Ladungsträgern in etwa gleichermaßen niedrige Leitfähigkeit aufweist. Diese Schicht ist im Beispiel etwa 1 - 40 µm, dick und besteht aus Selen, dotiert mit 0,1 bis 1 % Arsen. Wegen ihrer geringeren Leitfähigkeit für positive Ladungsträger baut sich hier die Raumladung effizienter auf, da sie nicht parallel zum Substrat auseinander fließen kann. Somit wird die Feldverbiegung forciert und zu einem großen Teil in der für Löcher gut leitfähigen Schicht 35 lokalisiert sein. Der Transfer der Ladungsträger zur Sammelelektrode, der nun überwiegend in der für Löcher leitfähigen Schicht 35 stattfindet, ist damit derart ermöglicht, daß in kurzer Zeit ein maximales Signal erhalten wird. Auch hier werden von den Sammelelektroden injizierte Elektronen in der Schicht 35 festgehalten. Daß sie zuvor Schicht 36 durchlaufen haben, spielt für die Funktionalität des Detektors keine Rolle.

Die Raumladungen in der halbleitenden Schicht 35 oberhalb der Dünnfilmtransistoren können u.U. Einfluß auf die Funktion dieser Schaltelemente haben. Um diesen Einfluß auszuschalten, können die Sammelelektroden je einen zusätzlichen Elektrodenteil 16 umfassen, der - wie in Fig. 8 dargestellt - oberhalb der Isolierschicht 13 den zugehörigen Dünnfilmtransistor überdeckt und der mit dem Elektrodenteil 11 in elektrischem Kontakt steht. Diese Elektrodenteile werden durch Metallisierung der Oberfläche erzeugt, die nach dem Aufbringen der isolierenden Schicht und dem Anbringen der Kontaktlöcher aber vor dem Aufbringen der halbleitenden Schicht 35 entsteht.

## Patentansprüche

1. Röntgenbilddetektor mit einer Vielzahl von für Röntgenstrahlung empfindlichen Sensoren mit folgenden Merkmalen:
- Jeder Sensor enthält eine Sammelelektrode (11) und ein Schaltelement (1), das die Sammelelektrode mit einer Ausgangsleitung (7) verbindet;
- zwischen den einzelnen Sammelelektroden (11) und einer Vorspannungselektrode (4) befindet sich eine Photoleiterschicht (3);
- die Sammelelektroden bilden zusammen mit Bezugselektroden (10) Kapazitäten (2), die durch im Photoleiter erzeugte Ladungsträger aufladbar sind;
dadurch gekennzeichnet, daß die Sammelelektroden je zwei in elektrischen Kontakt miteinander befindliche Elektrodenteile (11, 14) umfassen, daß der erste Elektrodenteil (11) jeweils in einem Bereich neben der zugehörigen Ausgangsleitung (7) angeordnet ist, daß der zweite Elektrodenteil (14) eine größere Fläche hat als der erste Elektrodenteil und sich zwischen diesem und der Vorspannungselektrode befindet, und daß sich zwischen dem zweiten Elektrodenteil (14) und der Ausgangsleitung (7) eine Isolierschicht befindet.

2. Röntgenbilddetektor mit einer Vielzahl von für Röntgenstrahlung empfindlichen Sensoren mit folgenden Merkmalen:
- Jeder Sensor enthält eine Sammelelektrode (11) und ein Schaltelement (1), das die Sammelelektrode mit einer Ausgangsleitung (7) verbindet;
- zwischen den einzelnen Sammelelektroden (11) und einer Vorspannungselektrode (4) befindet sich eine Photoleiterschicht (3);
- die Sammelelektroden bilden zusammen mit Bezugselektroden (10) Kapazitäten (2), die durch im Photoleiter erzeugte Ladungsträger aufladbar sind,
gekennzeichnet durch die weiteren Merkmale:
- Die Sammelelektrode (11) ist im Bereich neben der Ausgangsleitung (7) angeordnet;
- das Schaltelement (1) und die Ausgangsleitung sind von einer Isolierschicht (13) bedeckt;
- die Isolierschicht (13) und die Sammelelektrode (11) sind von einer halbleitenden Schicht (35) bedeckt;
- die halbleitende Schicht (35) ist so dotiert, daß sie für die in Richtung zur Sammelelektrode fließenden Ladungsträger eine im Vergleich zur Leitfähigkeit für Ladungsträger mit entgegengesetzter Polarität große Leitfähigkeit aufweist.

3. Röntgenbilddetektor nach Anspruch 2,
dadurch gekennzeichnet, daß sich zwischen der halbleitenden Schicht (35) und den Sammelelektroden (11) eine zusätzliche halbleitende Schicht (36) befindet, die sowohl für positive als auch für negative Ladungsträger eine geringe Leitfähigkeit aufweist.

4. Röntgenbilddetektor nach Anspruch 2,
dadurch gekennzeichnet, daß die Sammelelektroden (11, 16) aus je zwei Elektrodenteilen bestehen, die miteinander in elektrischem Kontakt sind, daß der erste Elektrodenteil im Bereich neben der Ausgangsleitung angeordnet ist, und daß die zweite Elektrode (16) sich auf der Isolierschicht über dem zugehörigen Schaltelement (1) befindet und ihrerseits von der halbleitenden Schicht (35) bedeckt wird.

5. Röntgenbilddetektor nach einem der vorhergehenden Ansprüche,
dadurch gekennzeichnet, daß die Photoleiterschicht (32) im wesentlichen aus Selen besteht.

6. Röntgenbilddetektor nach einem der Ansprüche 1 bis 4,
dadurch gekennzeichnet, daß die Photoleiterschicht im wesentlichen aus einem der Stoffe PbO, CdTe, CdSe oder HgI₂ besteht.

7. Röntgenbilddetektor nach einem der vorhergehenden Ansprüche,
dadurch gekennzeichnet, daß beiderseits der Photoleiterschicht (32) Schichten (31, 33) mit einer im Vergleich zur Photoleiterschicht (32) geringen Dicke vorgesehen sind, die so dotiert sind, daß sie für die Ladungsträger, die aus der Photoleiterschicht auf die ihnen benachbarten Elektroden (11; 4) zufließen, eine im Vergleich zur Leitfähigkeit für Ladungsträger mit der entgegengesetzten Polarität große Leitfähigkeit aufweisen.

8. Röntgenbilddetektor nach Anspruch 7,
dadurch gekennzeichnet, daß zwischen der Vorspannungselektrode (4) und der ihr benachbarten halbleitenden Schicht (35) eine weitere Schicht (34) angebracht ist, die aus dem gleichen Material besteht wie die Photoleiterschicht, aber wesentlich dünner ist als diese.

9. Röntgenbilddetektor nach Anspruch 1,
dadurch gekennzeichnet, daß die Isolierschicht (13) aus mehreren einander bedeckenden Teilschichten (131, 132), vorzugsweise aus unterschiedlichem Material, gebildet wird und daß die Öffnungen in den Isolierschichten, durch die hindurch die beiden Elektrodenteile (11, 14) miteinander in Verbindung stehen, umso größer sind, je weiter die Teilschicht vom ersten Elektrodenteil (11) entfernt ist.

## Claims

1. An X-ray image detector, comprising a plurality of X-ray sensitive sensors and having the following features:
- each sensor comprises a collecting electrode (11) and a switching element (1) which connects the collecting electrode to an output lead (7);
- a photoconductor layer (3) is provided between the individual collecting electrodes (11) and a bias electrode (4);
- in conjunction with reference electrodes (10), the collecting electrodes form capacitances (2) which are chargeable by charge carriers generated in the photoconductor;
characterized in that each of the collecting electrodes comprises two electrically contacting electrode portions (11, 14), the first electrode portion (11) being arranged in a respective area adjoining the associated output lead (7), the second electrode portion (14) having a surface area which is larger than that of the first electrode portion and being situated between the first electrode portion and the bias electrode, an insulating layer being provided between the second electrode portion (14) and the output lead (7).

2. An X-ray image detector, comprising a plurality of X-ray-sensitive sensors and having the following features:
- each sensor comprises a collecting electrode (11) and a switching element (1) which connects the collecting electrode to an output lead (7);
- a photoconductor layer (3) is provided between the individual collecting electrodes (11) and a bias electrode (4);
- in conjunction with reference electrodes (10), the collecting electrodes form capacitances (2) which can be charged by charge carriers generated in the photoconductor;
characterized in that it also has the following features:
- the collecting electrode (11) is arranged adjacent the output lead (7);
- the switching element (1) and the output lead are covered by an insulating layer (13);
- the insulating layer (13) and the collecting electrode (11) are covered by a semiconductor layer (35);
- the semiconductor layer (35) is doped so that for the charge carriers flowing in the direction of the collecting electrode it has a conductivity which is high in comparison with its conductivity for charge carriers of opposite polarity.

3. An X-ray image detector as claimed in Claim 2, characterized in that between the semiconductor layer (35) and the collecting electrodes (11) there is provided an additional semiconductor layer (36) which has a low conductivity for positive as well as negative charge carriers.

4. An X-ray image detector as claimed in Claim 2, characterized in that each of the collecting electrodes (11, 16) consists of two electrode portions which electrically contact one another, the first electrode portion being arranged at the area adjacent the output lead, the second electrode (16) being situated on the insulating layer above the associated switching element (1) and itself being covered by the semiconductor layer (35).

5. An X-ray image detector as claimed in any one of the preceding Claims, characterized in that the photoconductor layer (32) consists essentially of selenium.

6. An X-ray image detector as claimed in any one of the Claims 1 to 4, characterized in that the photoconductor layer consists essentially of one of the substances PbO, CdTe, CdSe or HgI₂.

7. An X-ray image detector as claimed in any one of the preceding Claims, characterized in that both sides of the photoconductor layer (32) are provided with layers (31, 33) which have a thickness which is small in comparison with that of the photoconductor layer (32), and which are doped so that their conductivity for the charge carriers flowing from the photoconductor layer to the neighbouring electrodes (11; 4) is high in comparison with their conductivity for charge carriers of opposite polarity.

8. An X-ray image detector as claimed in Claim 7, characterized in that between the bias electrode (4) and the neighbouring photoconductorlayer (35) there is provided a further layer (34) which is made of the same material as the photoconductor layer but which is substantially thinner than this layer.

9. An X-ray image detector as claimed in Claim 1, characterized in that the insulating layer (13) consists of several sub-layers (131, 132) which cover one another and which preferably consist of different materials, the apertures in the insulting layers, through which the two electrode portions (11, 14) contact one another being larger as the sub-layer is situated further from the first electrode portion (11).

## Revendications

1. Détecteur d'images radiologiques avec plusieurs capteurs sensibles aux rayons X présentant les caractéristiques suivantes :
- chaque détecteur contient une électrode collectrice (11) et un élément de circuit (1) qui relie l'électrode collectrice à une ligne de sortie (7);
- entre les électrodes collectrices individuelles (11) et une électrode de polarisation (4) se trouve une couche photoconductrice (3);
- les électrodes collectrices forment avec les électrodes de référence (10) des capacités (2) qui peuvent être chargées par les porteurs de charge générés par le photoconducteur,
caractérisé en ce que les électrodes collectrices comprennent respectivement deux parties d'électrode (11, 14) en contact électrique l'une avec l'autre, que la première partie d'électrode (11) est respectivement disposée dans une zone adjacente à la ligne de sortie correspondante (7), que la deuxième partie d'électrode (14) présente une surface plus grande que la première partie d'électrode et se situe entre celle-ci et l'électrode de polarisation et qu'une couche d'isolation se trouve entre la deuxième partie de l'électrode (14) et la ligne de sortie (7).

2. Détecteur d'images radiologiques avec plusieurs détecteurs sensibles aux rayons X présentant les caractéristiques suivantes :
- chaque capteur contient une électrode collectrice (11) et un élément de circuit (1) qui relie l'électrode collectrice à une ligne de sortie (7);
- entre les électrodes collectrices individuelles (11) et une électrode de polarisation (4) se trouve une couche photoconductrice (3);
- les électrodes collectrices forment avec les électrodes de référence (10) des capacités (2) qui peuvent être chargées par des porteurs de charge générés dans le photoconducteur,
caractérisé par les caractéristiques suivantes :
- l'électrode collectrice (11) est disposée dans la région adjacente à la ligne de sortie (7);
- l'élément de circuit (1) et la ligne de sortie sont recouverts par une couche d'isolation (13);
- la couche d'isolation (13) et l'électrode collectrice (11) sont recouvertes par une couche semi-conductrice (35);
- la couche semi-conductrice (35) est dotée de telle sorte qu'elle présente une grande conductibilité pour les porteurs de charge circulant dans la direction de l'électrode collectrice par rapport à la conductibilité pour les porteurs de charge de polarité opposée.

3. Détecteur d'images radiologiques selon la revendication 2,
caractérisé en ce qu'une couche semi-conductrice (36) supplémentaire se trouve entre la couche semi-conductrice (35) et les électrodes collectrices (11) et présente une faible conductibilité à la fois pour les porteurs de charge positifs et négatifs.

4. Détecteur d'images radiologiques selon la revendication 2,
caractérisé en ce que les électrodes collectrices (11, 16) se composent respectivement de deux parties d'électrode qui sont en contact électrique l'une avec l'autre, que la première partie d'électrode est disposée dans la région adjacente à la ligne de sortie et que la deuxième électrode (16) se trouve sur la couche d'isolation au-dessus de l'élément de circuit correspondant (1) et est recouverte pour sa part par la couche semi-conductrice (35).

5. Détecteur d'images radiologiques selon l'une des revendications précédentes,
caractérisé en ce que la couche photoconductrice (32) se compose essentiellement de sélénium.

6. Détecteur d'images radiologiques selon l'une des revendications 1 à 4,
caractérisé en ce que la couche photoconductrice se compose essentiellement d'une des matières suivantes : PbO, CdTe, CdSe ou HgI₂.

7. Détecteur d'images radiologiques selon l'une des revendications précédentes,
caractérisé en ce que, de part et d'autre de la couche photoconductrice (32), sont prévues des couches (31, 33) avec une épaisseur minime par rapport à la couche photoconductrice (32) qui sont dotées de telle sorte qu'elles présentent pour les porteurs de charge qui circulent de la couche photoconductrice vers les électrodes voisines (11; 4) une grande conductibilité par rapport à la conductibilité pour les porteurs de charge de polarité opposée.

8. Détecteur d'images radiologiques selon la revendication 7,
caractérisé en ce qu'une couche supplémentaire (34) qui se compose du même matériau que la couche photoconductrice mais est essentiellement plus fine que celle-ci est disposée entre l'électrode de polarisation (4) et la couche semi-conductrice (35) voisine de celle-ci.

9. Détecteur d'images radiologiques selon la revendication 1,
caractérisé en ce que la couche d'isolation (13) est formée de plusieurs couches partielles (131, 132) qui se recouvrent mutuellement en matériaux différents et que les ouvertures dans les couches d'isolation par lesquelles les deux parties d'électrode (11,14) sont en contact l'une avec l'autre sont d'autant plus grandes que la couche partielle est éloignée de la première partie d'électrode (11).
